# EUROPEAN PATENT APPLICATION

(11) **EP 4 083 913 A1**
(43) Date of publication of application: **02.11.2022**
(21) Application number: 21170982.9
(22) Date of filing: 28.04.2021
(51) Int. Cl.: G06T 7/00, G06K 9/00

(54) **COMPUTER-IMPLEMENTED CONVERSION OF TECHNICAL DRAWING DATA REPRESENTING A MAP AND OBJECT DETECTION BASED THEREUPON**

(71) Applicant: MapsPeople A/S, 9400 Nørresundby (DK)
(72) Inventor: HJERRILD, Jacob, Møller, 9400 Nørresundby (DK); VESTER, Kristian, Holm, 9400 Nørresundby (DK); ANDERSEN, Rasmus, Steenberg, 9400 Nørresundby (DK)
(74) Representative: Guardian IP Consulting I/S

(57) **Abstract**

This invention relates to a computer-implemented method of converting map data, the method (800) comprising the steps of: obtaining (801) map data according to a first data representation (101), the map data (101) representing or comprising a number of geometric entities, and converting (804, 805, 807) the map data according to the first data representation (101) to map data according to a second data representation (120), where the second data representation is a graph data representation (120).

## Description

### Field of the invention

The present invention relates generally to a computer-implemented method of converting map data and to a (related) computer-implemented method of detecting (or predicting a presence of) at least one object in map data. Additionally, the present invention relates to an electronic data processing system programmed and configured to execute either or both of the computer-implemented methods.

### Background

Maps (or rather data representing maps) are used by many different types of applications and for many different purposes. Outdoor map data may e.g. be used for automated determination of an outdoor route and indoor map data may e.g. be used for automated determination of an indoor route (and both may be combined). Such route(s) may simply be a route between point 'A' and 'B' or they may be a route being determined taking further data into account such as traffic density, total (travel) length between A and B, time from getting from A to B, accessibility data (stairs, ramps, ladders, etc.), access points/connections (doors/doorways, stairs, etc.), obstacles (walls, desks, etc.), and so on.

A further type of map data is map data that - together with other typical types of data - are used in connection with a so-called Geographic Information System (GIS).

Some of such data is generated manually or semi-automatically (e.g. by a GeoData Specialist (GDS) or similar) or even automatically, and is typically generated at least in part on the basis on technical drawing data (data of technical drawings), such as CAD (Computer Aided Design) data or similar. For semi-automatic or automatic generation, object detection (also equally referred to as object determination, object identification, object recognition, or similar) may be used to detect (at least candidates for) e.g. buildings, roads, road connections, obstacles, etc.

Various further methods within this context have been proposed to automate object detection that involve the use of neural networks or deep neural networks (DNN) or other suitable machine learning techniques where the technical drawing/CAD data is treated as or converted to a rasterised 2D image where a suitably trained neural network or similar performs image-analysis/-processing on/for the 2D image to identify or detect various objects of predetermined types and potentially extract additional data or information. However, at least some of these are not producing suitably good results in a reliable way and/or requires very large image resolutions thereby increasing the computational 'effort' and storage requirements significantly. Additionally, all rasterising typically involves some loss of detail or information, but rasterising technical drawings into a 2D image involves loss of many valuable details and information, such as (precise) geometric coordinates, resolution, attributes (CAD layer info), etc. In particular, so-called Convolutional Neural Networks (CNNs) are commonly used to perform image-analysis/-processing in general and also for technical drawing/CAD data. However, the convolutional nature of such CNNs - used to determine/derive lower order/more basic features of the image - assumes or works best for classes of images where neighbouring points of the image have similar attributes, which is not the case for technical drawing/CAD data.

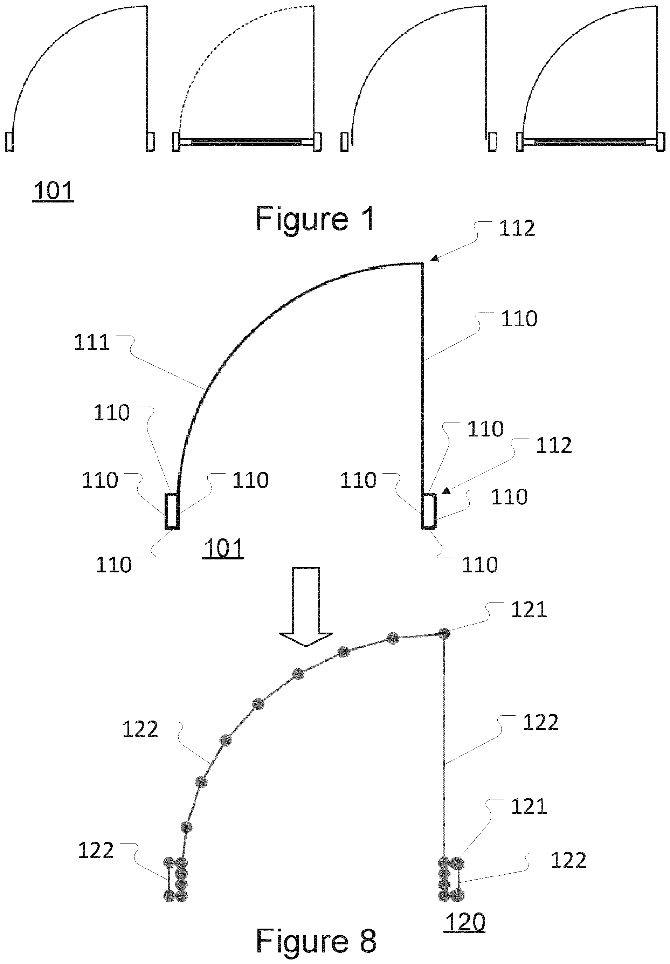

Furthermore, technical drawing data (such as CAD data) of different datasets/drawings in general are often quite inconsistent in terms of form, structure, representation, etc. of how the same items (e.g. a door or doorway) is represented or drawn since different people, companies, organisations, etc. have different ways and standards for their particular drawings. Figure 1 illustrates as an example four different ways (among many more) of drawing or representing a 'door' obtained from four different technical drawings/sets of CAD data. This inconsistency often leads to a need for GDS or other professional having to review and e.g. mark which objects are what and even carry out corrections, such as standardisations, before a final map is obtained or a map is obtained that can be used for reliable automatic or semi-automatic object detection.

It would be an advantage to be able to enable automation or at least enable automation to a higher degree when converting technical drawing data, e.g. or in particular CAD data, to map data in another format. It would also be an advantage to provide or facilitate subsequent data processing such as reliable object detection and/or map data creation and/or augmentation for map data, and in particular for converted map data. Finally, it would be an advantage to provide conversion and/or subsequent data processing in a computationally efficient and/or relatively fast way.

### Summary

It is an object to provide a computer-implemented method alleviating one or more of the above-mentioned drawbacks at least to an extent.

According to a first aspect, this is achieved, at least to an extent, by a computer-implemented method of converting map data, the method comprising:
- obtaining map data according to a first data representation (e.g. a technical drawing or CAD data representation), the map data representing or comprising a number of (i.e. one or more) geometric entities, and
- converting the map data according to the first data representation to map data according to a second data representation, where the second data representation is a graph data representation).

In this way, a map graph data representation is provided based on map data in a first data representation, e.g. or preferably CAD data, where the map graph data representation provides advantages as disclosed herein and in particular enable improvement of subsequent data processing such as reliable object detection and/or map data creation and/or augmentation for map data

In some embodiments, the obtained map data may also comprise further information such as a spatial (relative or absolute) position and/or orientation of each (or at least one or some of) the geometric entities. In particular, the obtained map data may comprise (2D) coordinates - according to a predetermined coordinate system e.g. according to or as defined by the first data representation - for each geometric entity or for respective parts of each geometric entity.

In some embodiments, converting the map data according to the first data representation comprises:
- for a geometric entity (e.g. one, some, or all of the first data representation or a layer thereof) of the number of geometric entities, the geometric entity comprising a number of line segments, each line segment comprising two opposite end points, where an end point of a line segment may be shared or may be non-shared, respectively, with an end point of another line segment,
   ∘ generating one node in the graph data representation for each non-shared end point,
   ∘ generating one node in the graph data representation for each shared end point,
- generating one edge in the graph data representation for each line segment so that a generated edge is connecting two generated nodes in the graph data representation that are generated for respective end points of a line segment that the edge is generated for.

In some embodiments, the computer-implemented method further comprises
- for geometric entities of the number of geometric entities that comprises at least a circular segment and/or one or more other non-line segments, converting or replacing such geometric entities to or by an approximating line segment version before or when converting such geometric entities to the graph data representation.

In some embodiments, the computer-implemented method further comprises
- assigning a weight for at least one edge (e.g. one, two, some, or all edges), the weight for an edge corresponding to a length of a line segment that the edge is or was generated for.

In some embodiments, the computer-implemented method further comprises
- determining a plurality of end points of line segments of the first data representation that are within a first predetermined vicinity or length of each other or of a single one of the plurality of end points, and
- replacing the determined plurality of end points within the first predetermined vicinity or length of each other or of a single one of the plurality of end points by a single end point retaining or having the line segments of the determined plurality of nodes.

As an alternative, one (e.g. a most suitable one) of the determined plurality of end points within the first predetermined vicinity or length of each other may be used instead of replacing them all by the single end point (while still retaining or having the line segments of the determined plurality of nodes).

In some embodiments, the computer-implemented method further comprises
- determining an end point of the first data representation, among end points of two line segments, that is located within a second predetermined vicinity or length of at least one of the two line segments, and
- replacing the determined end point by a new single end point on one or both of the line segments at the location where the two line segments intersect or, if not intersecting, would intersect if at least one of the two line segments is extended until the two line segments intersect.

In some embodiments, the computer-implemented method further comprises
- determining an end point of the first data representation, connected with only a single other end point (i.e. it is a direct neighbour) and being located within a third predetermined vicinity or length of a further other end point, and
- connecting the determined end point with the further other end point by a new line segment.

In some embodiments, the computer-implemented method further comprises
- determining two at least substantially parallel line segments of the first data representation that at least partly overlaps in their length direction and are distanced apart by less than a fourth predetermined vicinity or length in a direction substantially perpendicular to the length direction of the two at least substantially parallel line segments, and
- replacing the two at least substantially parallel line segments with a single line segment comprising the combined end points of the replaced two at least substantially parallel line segments.

In some embodiments, the computer-implemented method further comprises
- determining a position or set of coordinates of where two line segments of the number of geometric entities of the first data representation intersect, and
- determining whether an end point is located within a fifth predetermined vicinity or length of the determined position or set of coordinates, and if so then replacing the line segment for each of the two intersecting line segments with two line segments (i.e. totalling four line segments) and connecting respective line segments to the end point determined to be within the fifth predetermined vicinity or length of the determined position or set of coordinates.

In some embodiments, the computer-implemented method further comprises
- assigning a value for each of a number of predetermined features for each node of the graph data representation, wherein each of the predetermined features characterises an aspect of the node in question and its context.

In some embodiments, the values of the predetermined features are provided to an input part or input layer of a graph neural network, e.g. a graph convolutional neural network (e.g. or preferably according to the second aspect), for subsequent data processing.

In some embodiments, the predetermined features for a particular node comprises one or more selected from the group of:
- a minimum length of the edge(s) connected to the particular node,
- a maximum length of the edge(s) connected to the particular node,
- indication of which angle group(s) (see further in the following), if any, of a plurality of different angle groups, the particular node is determined to belong to (a node can belong to zero, one, or any number of angle groups - up to the number of applicable/available groups),
- for each angle group, a number of occurrences that the particular node is determined to belong to a respective angle group (this counts how many times the particular node is part of a particular angle group and then for each applicable/available group; e.g. if the particular node has two neighbours with a 90° angle between them, the count will be two for the angle group 90; the particular node may, if applicable, additionally be part of other angle groups for other angles),
- a number of one or more neighbouring nodes determined to be orthogonal to each other as seen from the particular node (for object detection of maps this is significant since a corner of a building typically or very often would comprise such a particular node with two (and then even only two neighbouring nodes),
- a circle probability representing a probability of the particular node being determined to be part of a circle (in some further embodiments, the probability that this node belongs to a circle geometric entity may e.g. be designated as "1" if it is determined to belong to a full circle, "0.5" if determined to belong to a half circle, and "0.25" if determined to belong to a quarter circle; the circle probability may also be derived in other ways),
- an indication of whether the particular node is determined to be part of a circle or not (e.g. "1" if the particular node has two and only two neighbours that belong to "angle group 180" (or a group as appropriate according to a used sampling/step angle) where those nodes furthermore forms (via respective connections/edges) a closed structure and otherwise "0"),
- an indication of whether the particular node is determined to be part of a half circle,
- an indication of whether the particular node is determined to be part of a quarter circle,
- an indication of whether the particular node is determined to be part of a corner (this may e.g. be given the value "1" if the particular node is determined to belong to the "angle group 90" and have two and only two connected neighbour nodes and be given "0" otherwise),
- a shortest Euclidean distance or length between the particular node and a node determined to belong to an angle group representing a quarter circle,
- a shortest topological graph distance or length between the particular node and a node determined to belong to the angle group representing a quarter circle (this shortest topological graph distance in this way is also often denoted as the "shortest path" within traditional graph theory),
- a shortest topological graph distance or length between the particular node and a node determined to belong to an angle group representing a half-circle (e.g. determined to belong to an "angle group 180"),
- a shortest Euclidean distance or length between the particular node and a node determined to belong to the angle group representing a half-circle (e.g. determined to belong to an "angle group 180"), and
- an identifier or indication of which type of geometric entity (e.g. arc, circle, ellipse, etc.) the particular node arises from.

One or more of the above features may respectively be derived by suitable processing on the first data representation and/or the graph data representation.

In at least some embodiments of the present context, "angle groups" as used herein are groups or classes of nodes that have a particular angle (giving name to a particular angle group), e.g. 90°, 180°, etc., or a suitable range of angles, e.g. 85° - 95°, 175° - 185°, etc., between the edges of two of the node's connected neighbouring nodes. As an example, "angle group 90" or similar comprises nodes having two connected neighbouring nodes with 90° (or alternatively 85° - 95° or another suitable range) between the (two) edges from a particular node to its two connected neighbouring nodes. As another example, "angle group 180" or similar comprises particular nodes respectively having two connected neighbouring nodes with 180°, 175° - 185°, or about 180° between the (two) edges connecting a particular node to its two connected neighbouring nodes.

In some embodiments, there is an angle group for each whole angle (1°, 2°, 3°, ..., 180°) and/or even including fractions of angles (e.g. 1.5°, etc.). However, some angle groups are of more significance than others in the present context of map data and detection or prediction of objects in map data.

Angle groups of particular significance for map data and in particular for detection or prediction of objects in map data have been found out to include "angle group 90" (e.g. of significance for detecting corners), "angle group 180" (e.g. of significance for detecting circles or part-circles, e.g. half-circle, quarter-circle, etc.).

For non-linear geometric entities (converted to a piecewise linear representation or approximation as disclosed herein), the sampling or step angle will influence the angle of the angle group. For example, sampling a (lossless) circle entity with a 10° sampling or step angle will produce a closed series of connected line segments (or edges) with end points (nodes) where the angle between two connected line segments (or edges) is 170° (180° minus sampling or step angle). For such, the angle group representing circles may be denoted "angle group 170" instead of "angle group 180". Further details and aspects of angle groups are disclosed elsewhere herein.

In some embodiments, the nodes of the graph data representation are non-ordered.

In some embodiments, the graph data representation is undirected.

According to a second aspect, the above object is achieved, at least to an extent, by a computer-implemented method of detecting (or predicting a presence of) at least one object in map data according to a first data representation, the map data representing or comprising a number of geometric entities, wherein one or more of the number of geometric entities represents or defines an object to be detected (or to have its presence predicted),
- converting the map data according to the first data representation to map data according to a second data representation, e.g. or preferably according to the method according to the first aspect and embodiments thereof, where the second data representation is a graph data representation,
- detecting or identifying one or more objects (e.g. doors, walls, stairs, desks, etc.) in the map data according to the second data representation (i.e. graph data) in response to providing the map data according to the second data representation to a computer program or routine implementing a trained graph artificial intelligence or machine learning method or component, e.g. or preferably a trained graph neural network (GNN), to generate or output the detected or identified one or more objects.

In at least some embodiments, the trained graph artificial intelligence or machine learning method or component is or implements a graph neural network (GNN). In at least some further embodiments, the trained graph neural network (GNN) is a graph convolutional (neural) network (GCN) node classification system. In some additional embodiments, the GCN is a graph attention network (GAT). Further details and embodiments of the GNN are disclosed herein.

According to a third aspect, an electronic data processing system is provided that comprises: one or more processing units connected to an electronic memory, wherein the one or more processing units are programmed and configured to execute the computer-implemented method according to the first and/or the second aspect as disclosed herein.

Further details and embodiments are disclosed in the following.

### Definitions

All headings and sub-headings are used herein for convenience only and should not be constructed as limiting the invention in any way.

The use of any and all examples, or exemplary language provided herein, is intended merely to better illuminate the invention and does not pose a limitation on the scope of the invention unless otherwise claimed. No language in the specification should be construed as indicating any non-claimed element as essential to the practice of the invention.

This invention includes all modifications and equivalents of the subject matter recited in the claims appended hereto as permitted by applicable law.

### Brief description of the drawings

Figure 1 schematically illustrates four exemplary different ways of drawing the same thing in a technical drawing, here in the form of a CAD drawing;
Figures 2A and 2B schematically illustrate rendered exemplary multi-layered technical drawing data, here in the form of CAD data;
Figure 3 schematically illustrates a rendering of a portion of the drawing data of Figures 2A and 2B in a Geographic Information System (GIS) data format as prepared by a GeoData Specialist (GDS) or professional;
Figure 4 schematically illustrates a rendering of a portion of the data of Figure 3 in a graphical map data format;
Figure 5 schematically illustrates a block diagram of one embodiment of converting map data according to a first data representation into map data according to a second data representation and detecting or predicting objects in the map data according to the second data representation as disclosed herein;
Figure 6 schematically illustrates additional elements of a further embodiment of the embodiments of Figure 5;
Figure 7 schematically illustrates a simplified flow chart of an embodiment of a computer program or routine implementing a computer-implemented method of converting map data as disclosed herein;
Figure 8 schematically illustrates a conversion of an exemplary geometric entity as disclosed herein;
Figure 9 schematically illustrates an exemplary optimisation according to an embodiment of a computer-implemented method of converting map data as disclosed herein;
Figure 10 schematically illustrates another exemplary optimisation according to an embodiment of a computer-implemented method of converting map data as disclosed herein;
Figure 11 schematically illustrates a further exemplary optimisation according to an embodiment of a computer-implemented method of converting map data as disclosed herein;
Figure 12 schematically illustrates yet another exemplary optimisation according to an embodiment of a computer-implemented method of converting map data as disclosed herein;
Figures 13A and 13B schematically illustrate another exemplary optimisation according to an embodiment of a computer-implemented method of converting map data as disclosed herein;
Figures 14, 15, and 16 schematically visualise exemplary nodes having different values of various features of an exemplary graph data representation; and
Figure 17 schematically illustrates a functional block diagram of embodiments of an electronic data processing device or system configured to implement various embodiments of the method(s) as disclosed herein.

### Detailed description

Various aspects and embodiments of a computer-implemented method of converting map data, a (related) computer-implemented method of detecting (or predicting a presence of) at least one object in map data, and an electronic data processing device or system configured to execute one or both of the computer-implemented methods as disclosed herein will now be described with reference to the figures.

The shown figures are schematic representations for which reason the configuration of the different structures as well as their relative dimensions are intended to serve illustrative purposes only.

Some of the different components are only disclosed in relation to a single embodiment of the invention, but are meant to be included in the other embodiments without further explanation.

Figure 1 schematically illustrates four exemplary different ways of drawing the same thing in a technical drawing, here in the form (as an example) of a CAD drawing/CAD data 101.

Illustrated are four different ways of drawing (and thereby representing) the exact same object - namely a door and doorway - taken from different technical drawings, being as an example a CAD drawing. This illustrates in a simple way, the diversity - and thereby the inconsistency - typically found in technical drawings even for simple things, which as mentioned presents a challenge in automated or semi-automated generation of map data from such technical drawing data and often necessitates a need for GDS or other professional having to review and e.g. mark which objects are what and even carry out corrections before a final map is obtained or a map is obtained that can be used for reliable automatic or semi-automatic object detection used in connection with map data generation.

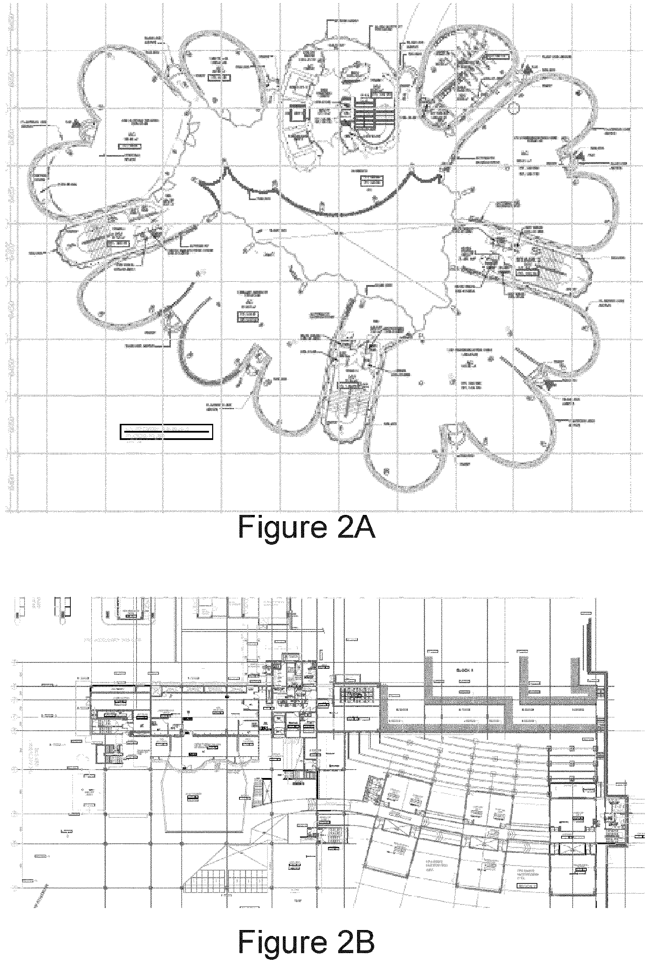

Figures 2A and 2B schematically illustrate rendered exemplary multi-layered technical drawing data, here in the form (as an example) of CAD data.

Illustrated in Figures 2A and 2B are different parts, respectively, of a technical drawing (as an example a CAD drawing) illustrating a typical complexity of such. As mentioned, this presents challenges for using such for generation of map data and in particular for reliable automatic or semi-automatic object detection used in connection with map data generation.

Figures 2A and 2B respectively illustrates a part of an exemplary typical CAD floor plan drawing. The content of the floorplan is organized in layers styled with different colors. It is up to the creator of a CAD drawing (that the CAD data defines or represents) how to organize the layers. Typically, the CAD drawings are made for construction purposes or for the planning of the construction of a building. Layers are in these cases typically organized by building materials or building components like doors, walls, windows, etc. Text labels are often added in the floorplans in separate CAD layers to provide additional info.

Technical drawings/CAD drawings can range from being very elaborate, for example naming/showing construction materials, walls with a width and insulation material, ventilation ducts, technical installations, etc., to be very simple in nature, for example just showing walls and other features as single lines.

In technical/CAD drawings, constructional features might not always be explicitly drawn, but can be implicit in nature, for example when a room is not digitized as a polygon but rather can be deduced by looking at a set of lines (i.e. representing walls) intersecting each other without having a shared point (i.e. two lines intersecting without sharing a vertex/point). Furthermore, technical/CAD drawings may contain drawing aids (e.g. helper lines with equal spacing) and/or non-constructional features such as legends, bill of materials, etc., which has nothing to do with the building layout as such.

Typically, the technical drawing data or the CAD data within the present context comprises a (often very large) number of geometric entities (e.g. ranging from a few thousands to more than a million geometric entities depending on purpose/application) where each geometric entity is represented or defined according to a vectorised (and lossless) geometric entity format.

Each geometric entity will be of one of a number of predetermined basic or fundamental types such as "point", "polyline", "polygon", "circle", "arc", "spline", "ellipse", "annotation", "multi-patch", etc. and have an own associated set of relevant parameters.

Merely rasterising such technical drawings into digital 2D images and using - even well trained -ANNs (artificial neural networks), DNNs (convolutional or otherwise), or other suitable machine learning techniques have not produced suitably good results in a reliable way. All rasterising typically involve some loss of detail or information, but rasterising such technical drawings into a 2D image involves loss of many valuable details and much information, such as (precise) geometric coordinates, resolution, attributes (CAD layer info), etc. that can be significant for proper map data generation and further uses.

This can be mitigated to some extent - but not fully or sufficiently - by rasterising into 2D images of (very) high resolution potentially leading to gigabyte-sized images. However, that increases the computational complexity and computational burden to a very large degree for subsequent data processing (such as object detection, map data creation and/or augmentation, etc.), increases storage requirements, and so on.

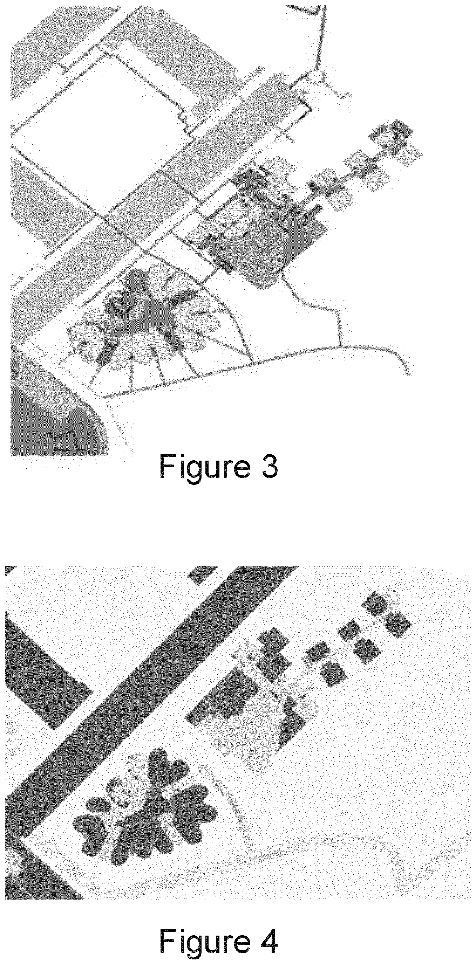

Figure 3 schematically illustrates a rendering of a portion of the drawing data of Figures 2A and 2B in a Geographic Information System (GIS) data format as prepared by a GeoData Specialist (GDS) or professional.

Illustrated is an example of a portion of the drawing data of Figures 2A and 2B as manually prepared by a GeoData Specialist (GDS) or similar in a Geographic Information System (GIS) data format using traditional suitable tools, which has involved a lot of time and work. More specifically, the GeoData Specialist (GDS) has manually interpreted and generalized the data from the CAD floor plan (Figures 2A and 2B) where drawings/data defining or representing the drawings are transformed into various geometric constructional and/or contextual objects like buildings, rooms, doorways, and routes for navigation purpose. The constructional and/or contextual objects can e.g. be applied with a suitable style scheme or similar so it is easier for the GDS to separate the different types of constructional and/or contextual objects.

Generally, geographic Information Systems (GISs) are typically used to analyse geographic data's spatial relations. It is thus significant that relations between geographic objects such as roads, streams, and areas, are mapped in detail. For example, if two roads have an intersection they must share a vertex/point where they intersect.

GIS data typically also follow a specific scheme that ranges from very complex topological data models, for example roads are boundaries for areas that again contain buildings, to more simple data models for each object, for example one model for roads, another for areas, a third for buildings, etc.

Objects in GIS data can have one or more attributes describing the properties of the object, for example the width of a road, an area's class, or a specific type of building. GIS can combine spatial queries with attributes thus enabling users to perform complex and detailed analysis of spatial data and their properties and how they relate to each other and other objects.

Figure 4 schematically illustrates a rendering of a portion of the data of Figure 3 in a graphical map data format.

Illustrated is an image of a final graphical map that may be presented to an end user e.g. or preferably in map applications designed for web and/or mobile devices and/or used in any other suitable manner e.g. for further subsequent data processing. A colour scheme is applied to the map objects to aid users in distinguishing the map objects from each other. The graphical map here illustrates how a map may look like when applying aspects of the present invention to suitable input data.

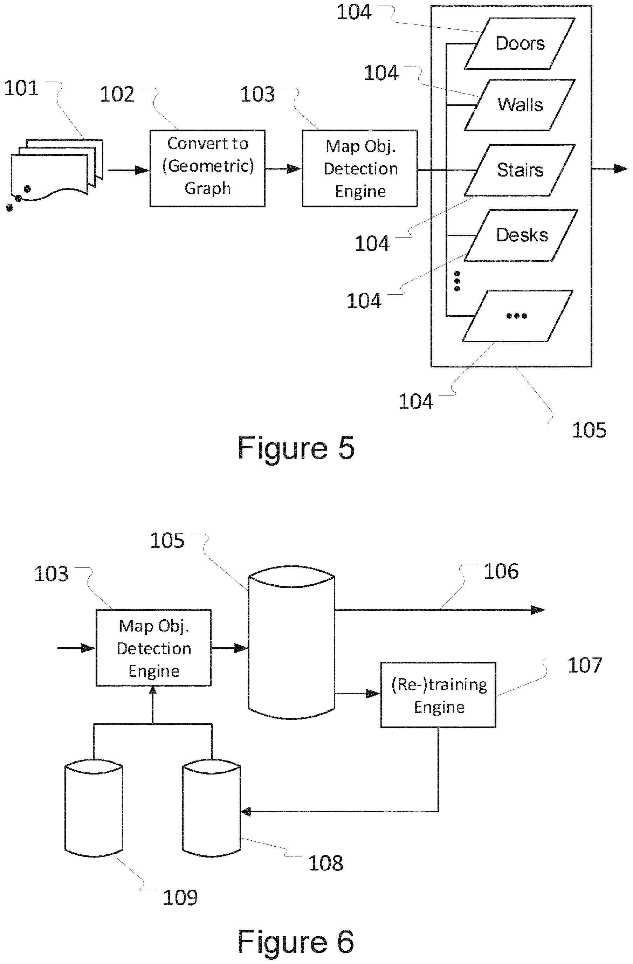

Figure 5 schematically illustrates a block diagram of one embodiment of converting map data according to a first data representation into map data according to a second data representation and detecting or predicting objects in the map data according to the second data representation as disclosed herein.

Illustrated is map data 101 according to a first data representation being technical drawing data, such as CAD data. The map data 101 comprises one or more datasets or files of map data, each comprising a number (in principle one or more) of geometric entities as disclosed herein. Typically, a dataset or file of map data 101 in the present context will comprise a relatively large number of geometric entities of various types (see e.g. Figures 2A and 2B for an example). The number of geometric entities will vary from dataset to dataset depending on use, complexity, overall scale, etc. and e.g. be in the range from a few thousands to more than a million geometric entities. It is not uncommon that a dataset/file for a building may comprise about three hundred thousand geometric entities or so for each single floor of the building, which results in a significant amount of data to subsequently be processed. As mentioned, technical drawing data and CAD data typically defines data according to a vectorised and lossless geometric entity format with relevant parameters and associated values depending on the specific basic or fundamental type of a particular geometric entity and how it is to be rendered/represented. The types may e.g. comprise one or more of "point", "polyline", "polygon", "circle", "arc", "spline", "ellipse", "annotation", "multi-patch", etc., which are known as such by itself. Each geometric entity (depending on type) may also comprise or be associated with a spatial (relative or absolute) position within a suitable coordinate system or similar reference framework.

As an example, a polyline geometric entity (being a set of two or more vertices that form a connected set of lines) may e.g. comprise or represent a "Polyline" identifier or label and the data {"points": [[100,100], [100,200], [200,300], [300,300]]} (representing a polyline having four vertices as an array of points). As further examples, a polygon geometric entity (being a polyline with three or more vertices that begin and end in a same point) may e.g. comprise or represent a "Polygon" identifier or label and the data { "points": [[100,100], [200,100], [150,150], [100,100] ]} (representing a triangular polygon as an array of points), and a circle geometric entity (often represented by a centre of the circle and the circle's radius) may e.g. comprise or represent a "Circle" identifier or label and the data {"point": [100,100], "radius": 50} (representing a circle as an object with a centre in 100,100 and a radius of 50).

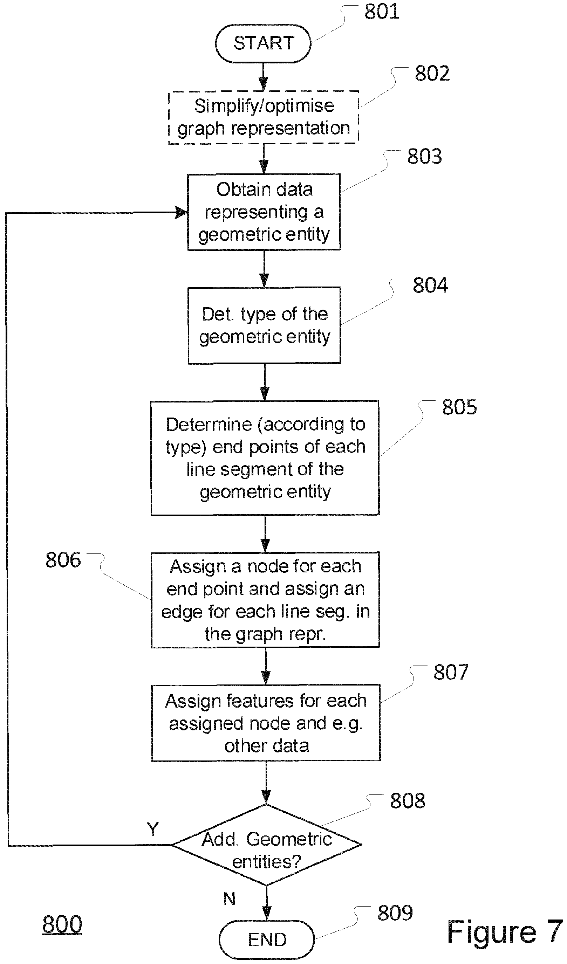

A converter or conversion element 102 receives at least one file or dataset (or a part thereof) according to the first data representation and converts it as disclosed herein. Accordingly, map data in the first data representation is converted into map data according to a second data representation being a graph data representation (see e.g. 804, 805, 807 in Figure 7) comprising or representing a number of nodes and a number of edges appropriately connecting the nodes. The graph data representation is by its nature a topological representation and in at least some further embodiments, the nodes of the graph data representation are non-ordered and/or the graph data representation is undirected. More specifically, the first data representation (or more specifically, the geometric entities thereof) comprises or represents a number of line segments (to otherwise be rendered in 'normal' applications) where each line segment comprises two opposite end points (may also be referred to as a first and a second point or as a start and end point respectively) and where the conversion comprises generating a node in the graph data representation for each end point of the map data according the first data representation. An end point of a line segment may be shared or may be non-shared with an end point of another line segment depending on whether the line segments are directly connected or not. An end point may be shared with more than one other end point (e.g. for a 'star' structure or shape, polygons, other closed structures or shapes, etc.). If an end point is shared by one or more other end points (typically signifying that they have the same coordinates) only a single node is generated in the graph data representation for all of these at least according to some embodiments of conversion as disclosed herein. Additionally, the conversion comprises generating an edge in the graph data representation for each line segment where a given edge connects the given nodes (in the graph data representation) that was or is assigned for the respective two end points of a particular line segment that the given edge is generated for. A node for a shared end point is connected by two or more edges (one edge for each line segment having an end point being the shared end point). Figure 8 illustrates a simple example of such a conversion (converting a geometric entity representing a door in a CAD data representation to its graph data as disclosed herein).

One or more, typically several, of the geometric entities according to the first data representation may also comprise or represent one or more non-line segments, i.e. segments that are not a line segment or made up solely of line segments. Such could e.g. be geometric entities of the types "circle", "arc", "spline", "ellipse", etc.

In at least some embodiments, such non-line segment entities are (prior or during conversion to the graph data representation) converted or replaced by an approximating line segment version.

For circle, arc, ellipse, etc. types of geometric entities, an approximating line segment version could e.g. be derived by any suitable piecewise linear approximation or similar and could e.g. be based on the official PostGIS ST_CurveToLine function or functionality (see e.g. postgis.net/docs/ST_CurveToLine.html). The sampling or approximation could e.g. be based on a variable specifying a sampling or step angle defined in relation to the centre of the circular shape to a first endpoint (becoming the first node). The angle is incremented in fixed steps and a point of the circular shape being at the incremented angle becomes the node for that step. Accordingly the circular shape is converted or replaced. Such angle could e.g. be 3°, 5°, 10°, 15° or any other suitable angle depending on specific use. 5° to 10° or about 5° to about 10° has been seen to offer a good balance between subsequent reliable detection/prediction and computational effort and storage requirements (the smaller the angle, the more line segments will be used). In some embodiments, if a circular shape is not divisible by a specified sampling or step angle, the sampling or step angle may be replaced (approximated by) one that does (e.g. replacing a sampling or step angle of 11° with one that is 10° for a quarter circle) to have approximating line segments of equal length. Figure 8 illustrates one example of a circular segment being piecewise approximated and converted to a graph data representation.

One exemplary embodiment of a flowchart of such a computer-implemented conversion method is illustrated in Figure 7 and Figures 8 and 14-16 schematically illustrate visualisations of exemplary graph data representations or parts thereof.

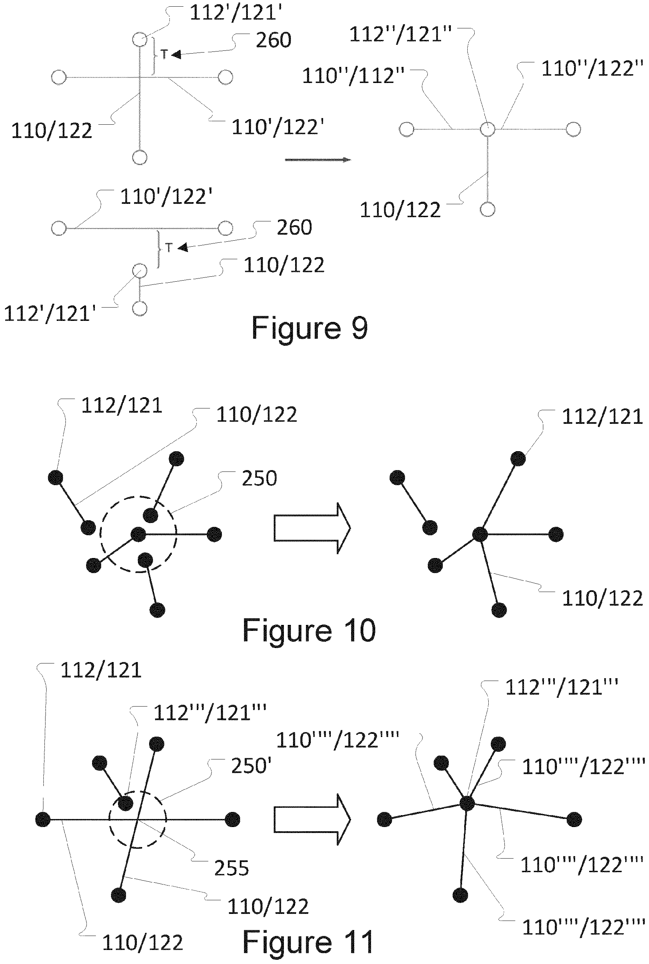

The conversion may also comprise one or more simplifying or optimising functions/methods (done prior, during, and/or after the actual conversion) to increase the usability of the graph data representation and/or to decrease the computational complexity of it for subsequent data processing. Some such simplifying or optimising functions/methods are described in connection with Figure 7 (step 802) and Figures 9 - 13B.

The graph data representation enables efficient subsequent data processing such as reliable object detection or at least reliable object prediction and/or map data creation and/or augmentation as disclosed herein.

In at least some embodiments, the conversion 102 further comprises embedding relevant data of the map data according to the first data representation (e.g. CAD data) in the graph data representation. The relevant data may comprise values for relevant parameters (such as geometry parameters (e.g. stored according to formats such as GeoJSON, Well Known Text (WKT), etc.), CAD Layer information, version, date, etc.) for the converted geometric entities and in particular the relevant coordinates of the converted geometric entities within an overall/reference coordinate system. In this way, the graph data representation can carry any geometric and any topological relation between the geometric entities that is (decided to be) embedded in the graph data representation at any given CAD coordinate (such that the exact same coordinates are represented in the graph data representation) or put in other words - the graph data representation can be fully compliant with the original technical drawing/CAD data such that data and information can be transferred back and forth between technical drawing/CAD domain and the graph domain without any loss of relevant detail or orientation.

In some further embodiments, additional attributes, data, etc. such as CAD layer info, descriptive attributes, etc. can also be carried over.

In some further embodiments, during or after conversion a weight is assigned (or generated and assigned) for each edge of the graph data representation (or at least one or some of them), where the weight is or corresponds to the length of a line segment that the edge is or was generated for. The weight may e.g. be a normalized length instead of an actual length. The weight may e.g. be used to derive one or more features (such as a minimum or a maximum length of edge(s) connected to a particular node or other; see e.g. further in the following), setting (or at least influencing) the topological distances in the graph data representation according to the lengths of the line segments that the edges are based on (by setting their respective weights to be equal to the respective lengths), whereby e.g. a topological shortest path directly is influenced or based on respective lengths, and so on.

Additionally (at least in some embodiments), relevant values for a number of predetermined features, e.g. or preferably in the form of a feature vector ('*f'*) or similar, is generated or derived for each node of the graph data representation, where each of the predetermined features characterises an aspect of the node in question and its context. The relevant values for the features may e.g. be derived during the conversion. The features/feature vector may e.g. be supplied to an input layer or input part of a graph neural network (GNN) as disclosed herein. The particular selection of features will have a significant impact on the efficiency, reliability, and/or usability of a GNN subsequently processing the graph data representation for a particular purpose such as object detection or object prediction.

The number of features or the length of the feature vector is typically the same for all nodes of a particular graph data representation, but it may and typically will, for a particular node, contain non-zero values for only a sub-set thereof.

In some embodiments, the predetermined features for a particular node comprises one or more selected from the group of (or one or more selected from the group consisting of) and as disclosed herein:
- a minimum length of edge(s) connected to the particular node,
- a maximum length of edge(s) connected to the particular node,
- indication of which angle group(s) (if any) of a plurality of different angle groups, the particular node is determined to belong to,
- for each angle group, a number of occurrences that the particular node is determined to belong to a respective angle group,
- a number of one or more neighbouring nodes determined to be orthogonal to each other as seen from the particular node,
- a circle probability representing a probability of the particular node belonging to a circle geometric entity,
- an indication of whether the particular node is determined to part of a circle geometric entity or not,
- an indication of whether the particular node is determined to be part of a half circle,
- an indication of whether the particular node is determined to be part of a quarter circle,
- an indication of whether the particular node is determined to be part of an angle group representing a corner,
- a shortest Euclidean distance or length to a node determined to belong to an angle group representing a quarter circle,
- a shortest topological graph distance or length to a node determined to belong to the angle group representing a quarter circle,
- a shortest topological graph distance or length to a node determined to belong to an angle group representing a half-circle,
- shortest Euclidean distance or length to a node determined to belong to the angle group representing a half-circle,
- shortest topological graph distance or length to a node determined to belong to the angle group representing a half-circle, and
- an identifier or indication of which type of geometric entity (e.g. arc, circle, ellipse, etc.) the particular node arises from.

The feature vector, *f*, serves the purpose of describing/representing the qualities or characteristics of node, *n,* in a *d*-dimensional space of real numbers, *R*, i.e. *f*:*n* → *R^{d},*
where each entry in *f* is a real number respectively representing each of the relevant/selected/used features (e.g. as mentioned above and/or disclosed herein). The features may e.g. comprise one or more of "minimum length", "maximum length", "circle probability", "is circle", "is half circle", "is quarter circle", "is corner", "angle group 90", "angle group 180", or any other suitable angle group, etc. as disclosed herein.

After the map data has been converted into a graph data representation it is, at least in some embodiments and as illustrated, received and used as input by a suitable map object detection engine (also referred to herein as prediction engine) 103. The generated graph data representation (being provided to the map object detection engine 103) is herein also referred to as a geometric graph (data representation). In at least some embodiments, the map object detection engine 103 is or comprises a suitably trained GNN and the generated graph data representation (being the output of the conversion 102) is provided to the input layer of the (appropriately trained) GNN, which in turn outputs (as a result) the nodes and associated edges of the graph data representation being determined or predicted (by the GNN) to be one of a number of possible different types/categories of objects, such as a 'door', a 'wall', a 'stair', and/or any other type useful in creating or processing map data within the present context. The number of different detectible types (and their nature) depends on how the GNN is modelled and how it is trained and in particular on which features/which feature vector is used together with the conversion 102 (and used in the training of the GNN).

The generated graph data representation can in principle be provided to any suitably trained GNN - suitably trained to produce a meaningful output. In some embodiments, the GNN is a Graph Convolutional (Neural) Network (GCN) node classification system where an output graph (i.e. the output produced by the GCN) has the same dimension as the input graph of the GCN. The output graph comprises a label or similar identifier (of a plurality of such labels or identifiers) for each node designating a respective node as belonging to a predicted or determined object (as predicted or determined by the GCN) as described or identified by the respective label. As examples, if an input node is predicted or determined by the GCN to belong to a door object then the output node corresponding to the input node comprises a label or identifier designating a 'door', if an input node is predicted or determined by the GCN to belong to a wall object then the output node corresponding to the input node comprises a label or identifier designating a 'wall', etc.

In some embodiments, the GNN is trained as a supervised node classification system, by using any Graph Convolutional Network. In some further embodiments, a model is trained based on an optimally selected feature set, which is a subset of the full d-dimensional set, specifically selected for detecting the specified objects such as doors, walls, rooms, elevators, stairs, etc. The automatic feature selection can be done by principal component analysis, filter or wrapper methods or even by trying all combinations.

In some embodiments, the GNN/GCN receives the generated graph data representation at the input layer or input part or similar that performs aggregation and maps the input features, using a fully connected layer, to an output equal to the number of network nodes *n* in hidden layers of the GNN/GCN. The hidden layers perform aggregation followed by a mapping to size *n*. Additionally, an output layer performs aggregation and maps the result, e.g. or preferably using a fully-connected layer, to c nodes equal to the number of object classes. For a binary classifier for a single object (e.g. door vs non-door) c is equal to 2. Having initialized a network, a forward pass can be performed using the graph data representation and its feature matrix and a convolution layer of each network may comprise aggregation as generally known.

In some embodiments, the map object detection (or prediction) engine 103 is configured to function as a detection service meaning that it will predict one type of object using a specific model specifically trained for this given purpose of detection. One advantage of doing so, is that each type of object, e.g. door, wall, etc., can have a corresponding optimal detection or prediction model associated specifically for it, this particular model will have its own neural network depth, width, network hyper-parameters, etc. This is e.g. illustrated further in Figure 6. Alternatively, only a single trained model is used to detect all types of relevant objects. Furthermore, the input graph data representation to the engine 103 may also additionally comprise certain statistical qualities that can be used as further criteria for selecting the given detection model to be used by the engine 103. Such statistical qualities may e.g. be based on mean and standard deviations of distance-based metrics, topological distances in the graph, clustering coefficients describing distribution of density in the graph, average node degrees or node centrality, etc.

In some further embodiments, the GNN is a so-called graph attention network (GAT) (see e.g. arxiv.org/abs/1710.10903), which is a specific subset of a convolutional (in a graph neural network context) graph neural network. It has surprisingly been determined that GAT GNNs are particular useful and well-performing in relation to reliable object detection on graphs representing or being converted from technical drawing data/CAD data as disclosed herein, since attention weights between neurons of the GNN are trained. There exist various types or subclasses of GAT GNNs.

As mentioned, in some embodiments, the GCN is a so-called Graph Attention Network (GAT). In alternative embodiments, the GCN is a graph data representation according to the GraphSAGE framework (see e.g. snap.stanford.edu/graphsage/), a Topologically Adaptive Graph Neural Network (TAGCN) (see e.g. arxiv.org/abs/1710.10370), an Attention Based GNN (AGNN) (see e.g. github.com/dawnranger/pytorch-AGNN), a GIN (see e.g. workshops.inf.ed.ac.uk/accml/papers/2020/AccML_2020_paper_6.pdf), an APPNP (see e.g. arxiv.org/pdf/1810.05997.pdf), or any other suitable GCN within this class or corresponding ones.

As an alternative, to providing the geometric graph to a suitable GNN, the geometric graph may be applied to so-called semi-supervised auto-encoders for abnormality detection (i.e. finding abnormal objects in the CAD data) or unsupervised methods by leaving out any (class) labels or identifiers (e.g. 'door', 'wall', etc.) or selecting certain types of data based on a particular need or use.

Accordingly, the map object detection engine 103 generates data 104 of which nodes and edges of the input graph data representation that is determined (according to the engine 103) to be of a certain predetermined type or category. In some embodiments (and as illustrated), the map object detection engine 103 generates respective data 104 for each specific object type/category, and store such separately in a suitable data storage structure 105 such as one or more databases. As an example and as illustrated, respective data representing identified/determined doors 104, walls 104, stairs 104, desks 104, etc. is derived individually. This data can then be used for various purposes e.g. for reliable and efficient map creation, map augmentation, indoor routing, outdoor routing, etc.

Figure 6 schematically illustrates additional elements of a further embodiment of the embodiments of Figure 5.

Illustrated is a map object detection or prediction engine 103 that may correspond to the engine of Figure 5 and furthermore may receive input also as explained in connection with Figure 5 (i.e. a graph data representation as converted from a first data representation). Further illustrated is a suitable data storage structure 105, such as one or more databases, comprising respective data for each detected or predicted specific object type/category (see e.g. 104 in Figure 5), which may be used for various purposes as indicated by arrow 106.

Additionally shown is a suitable data storage structure 109 (such as one or more databases) storing different models - e.g. or preferably one specifically for each object type or category, e.g. door, wall, stair, desks, etc. (see e.g. 104 in Figure 5), that the engine 103 is to be able to detect or predict, and a suitable data storage structure 108 (such as one or more databases) storing different training sets (one or more for each model of 109). A (re-)training engine 107 is connected to receive input from the data storage structure 105 and to generate and/or update the training sets of the data storage structure 108 and potentially also the model(s) of the data storage structure 109 e.g. involving further input. In this way, the quality of detection or prediction of the engine 103 may iteratively be improved.

Figure 7 schematically illustrates a simplified flow chart of an embodiment of a computer program or routine implementing a computer-implemented method of converting map data as disclosed herein.

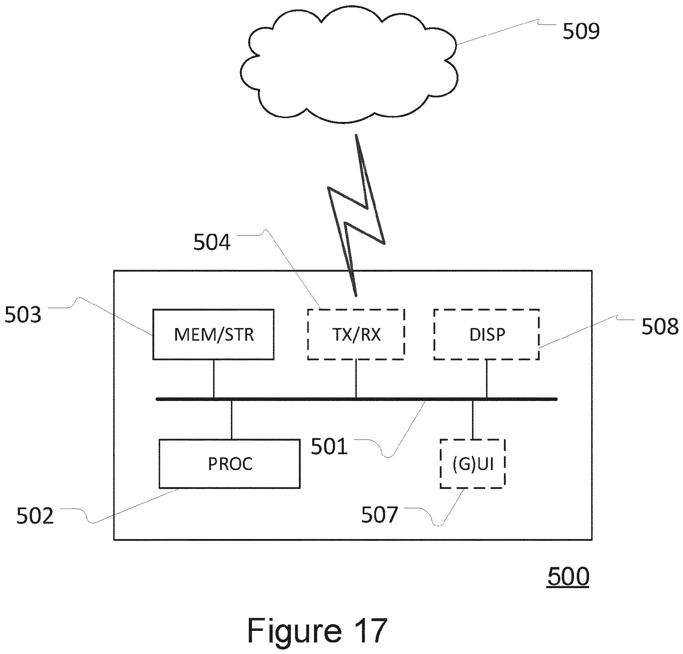

Illustrated in Figure 7 is a schematic flow chart of embodiments of a computer-implemented method 800 of converting map data where the computer-implemented method is or may be performed by an electronic data processing apparatus (e.g. such as the one illustrated as 500 in Figure 17 and/or by a converter or conversion element as disclosed herein (e.g. such as 102 in Figure 5).

At step 801, the method 800 starts and potentially is initialized, etc.

At optional step 802, one or more simplifying or optimising functions/methods is executed for map data according to a first data representation being technical drawing data, such as CAD data (see e.g. 101 in Figure 5) thereby simplifying and/or optimising the first data representation prior to conversion and thereby in turn simplifying and/or optimising the resulting graph data representation and in particular subsequent processing thereof.

In some embodiments, one such simplifying or optimising function/method (which may be instead of or in addition to the simplifying or optimising function(s)/method(s) mentioned herein) comprises determining a plurality of end points of the first data representation that are within a first predetermined vicinity or length/distance of each other or of a single one of them and then replacing the determined end points (then being within the first predetermined vicinity or length of each other) by a single end point where the single end point retains or is assigned with all the line segments of the determined end points (to being within the first predetermined vicinity or length/distance). Stringently speaking, the determined end points need not actually be replaced by an end point but instead one of the existing end points (e.g. the most suitable end point according to one or more predetermined criteria) of the determined end points is selected to be kept (while removing the others). In some further embodiments, the value of the first predetermined vicinity or length can be controlled according to use and/or preference. The value may be set universally or can even be set dynamically (e.g. one region of the first data representation is set to one value while another region of the first data representation is set to another value, end points arising from a particular type of geometric entity is set to one value while end points arising from another particular type of geometric entity is set to another value, etc.). As examples, the value of the first predetermined vicinity or length may e.g. be selected as one value selected from/corresponding to 1, 2, 3, 4, 5, or more millimetres, e.g. about 1 to about 10 millimetres and even below 1 millimeter depending on specific implementation/use and e.g. as obtainable from the coordinates and associated scale of the underlying technical drawing/CAD data of the first data representation. Such function/method can and typically will greatly simplify first data representation and in turn the resulting graph data representation (as the number of end points and thereby nodes are reduced) and thereby reduce any subsequent computational processing thereof and/or reduce storage requirements for the graph data representation often without sacrificing too much accuracy and/or reliability, if any practically speaking. An example of a result of such function/method is e.g. illustrated in Figure 10.

In some embodiments, one other such simplifying or optimising function/method (which may be instead of or in addition to the simplifying or optimising function(s)/method(s) mentioned herein) comprises determining an end point among end points of two line segments (in vicinity of each other), where the end point is located within a second predetermined vicinity or length of at least one of the two line segments, and replacing the determined end point by a new single end point on one or both of the line segments at the location where the two line segments intersect (i.e. at the coordinate of intersection) or, if not intersecting, would intersect if at least one of the two line segments is extended until the two line segments intersect. In effect, line segments within a relatively small proximity (as determined by the second predetermined vicinity or length) is 'snapped' together. As examples, the value of the second predetermined vicinity or length may e.g. be selected as one value selected from/corresponding to between more than zero to about 1 centimetre in the low end of the range (e.g. 1-2 millimetres) depending on specific implementation/use. The value of the second predetermined vicinity or length may be set universally or can even be set dynamically. An example of a result of such function/method is e.g. illustrated in Figure 9.

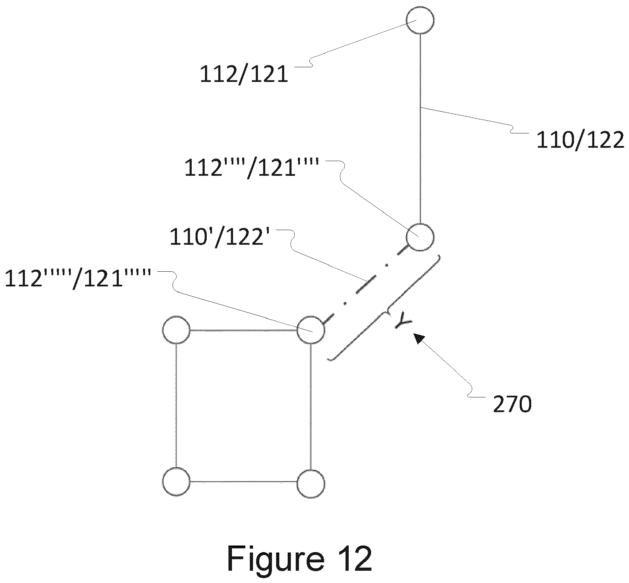

In some embodiments, one other such additional simplifying or optimising function/method (which may be instead of or in addition to the simplifying or optimising function(s)/method(s) mentioned herein) comprises determining an end point connected with only a single other end point (i.e. it has only one direct neighbour connected by a single line segment) and where the end point located within a third predetermined vicinity or length of a further other end point (i.e. the further other end point is not connected to the determined end point or its neighbour), and connecting the determined end point with the further other end point by a new line segment. This connects disconnected line segments with other parts and in turn creates a more connected graph data representation. As examples, the value of the third predetermined vicinity or length may e.g. be selected as one value selected from/corresponding to between more than zero and up to 4 centimetres depending on specific implementation/use. The value of the third predetermined vicinity or length may be set universally or can even be set dynamically. An example of a result of such function/method is e.g. illustrated in Figure 12. The length of the new line segment may be set in different ways depending on specific implementation/use. In some embodiments, the length is set so that length is larger than the third predetermined vicinity or length and smaller than about 1 centimetre, typically or at least some times about 1 - 2 millimetres. In other embodiments (where the simplifying or optimising function/method involving the first predetermined vicinity or length as described above and as illustrated in Figure 10 is also carried out), the length is set so that length is larger than the third predetermined vicinity or length and smaller than the first predetermined vicinity or length (also illustrated as 250 in Figure 10).

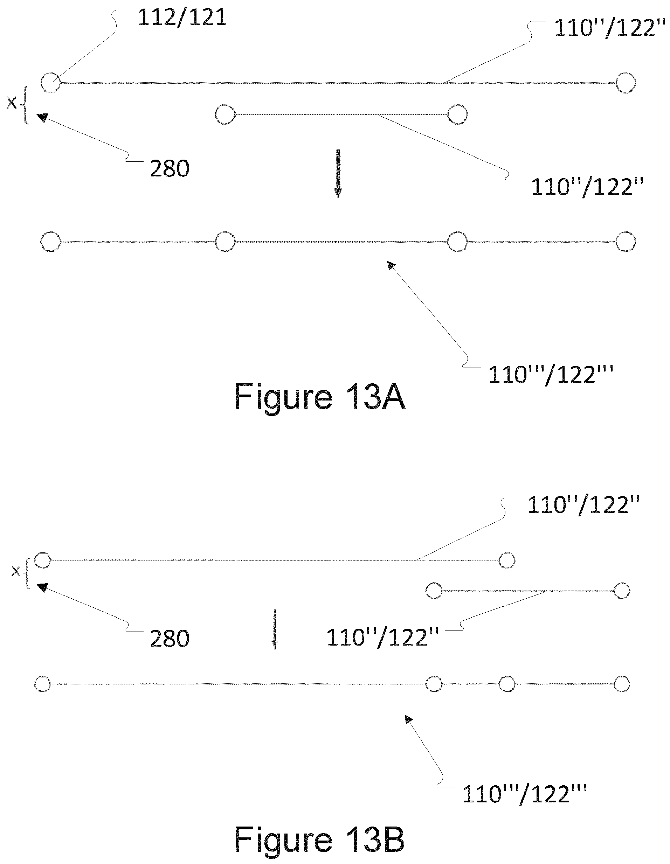

In some embodiments, one other such further simplifying or optimising function/method (which may be instead of or in addition to the simplifying or optimising function(s)/method(s) mentioned herein) comprises determining two at least substantially parallel line segments of the first data representation where the two at least substantially parallel line segments at least partly overlaps in their length direction and furthermore are distanced apart only by less than a fourth predetermined vicinity or length in a direction substantially perpendicular to the length direction of the two at least substantially parallel line segments, and replacing the two at least substantially parallel line segments with a single line segment comprising the combined end points of the replaced two at least substantially parallel line segments. In effect, two parallel or substantially parallel at least partly overlapping line segments within a certain (relatively small) distance of each other will be merged as one while retaining all end points of the relevant line segments (and thereby retaining all nodes in the resulting graph data representation). As examples, the value of the fourth predetermined vicinity or length may e.g. be selected as one value selected from/corresponding to between more than zero to about 0.5 or 1 centimetres depending on specific implementation/use. The value of the fourth predetermined vicinity or length may be set universally or can even be set dynamically. The value of the fourth predetermined vicinity or length may be set universally or can even be set dynamically. Two exemplary results of such function/method are e.g. illustrated in Figures 13A and 13B.

In some embodiments, yet a further such simplifying or optimising function/method (which may be instead of or in addition to the simplifying or optimising function(s)/method(s) mentioned herein) comprises determining one or more, e.g. all, intersecting line segments (of the underlying technical drawing/CAD data and for each intersection involving two line segments determining or obtaining the set of coordinates of where two line segments intersect. After the set(s) of coordinates have been determined or obtained then the simplifying or optimising function/method checks (for each set of coordinates of an intersection) whether an end point is located within a fifth predetermined vicinity or length of a particular set of coordinates and if so, replacing the line segment for each of the involved two intersecting line segments with two line segments (then totalling four line segments) and connecting the respective line segments to the end point determined to be within the fifth predetermined vicinity or length of the particular set of coordinates. The line segments - at their respective opposite end - retains their connections to respective end points. In a sense, an existing end point (within a suitable distance or length) is used as a connection end point for an intersection. In case of two or more end points being within the fifth predetermined vicinity or length, one can be selected according to one or more additional criteria (e.g. selecting the closest). In this way, the complexity of the first data representation and in turn the graph data representation is reduced typically reducing any subsequent computational processing thereof often without sacrificing too much reliability if any, practically speaking. In effect, the graph data representation becomes more connected and connected in a less complex manner. In some further embodiments, the value of the fifth predetermined vicinity or length can be controlled according to use and/or preference. The value may be set universally or dynamically, e.g. as described above or in another suitable way. As examples, the value of the fifth predetermined vicinity or length can e.g. correspond to up to about 0.5 to 1 centimetres or up to about 2 centimetres or alternatively more in the 'real world' e.g. as obtainable from the coordinates and associated scale of the underlying technical drawing/CAD data. An example of a result of such function/method is e.g. illustrated in Figure 11.

Step 802 is as mentioned optional and may be fully omitted or may comprise one or more other simplifying or optimising functions/methods instead or in addition to one or more of the functions/methods mentioned above. One or more of the simplifying or optimising functions/methods (or parts thereof) may also be executed 'later' in the flow chart at suitable steps or locations (as new steps). One function/method of step 802 (or a part thereof) may also be executed later while another (or a part thereof) is executed at step 802.

The above mentioned simplifying or optimising functions/methods have been described as working for/on the first data representation/CAD data and at least in some embodiments they are respectively working only on data of a single layer (at least at a time).

Furthermore, the above mentioned simplifying or optimising functions/methods (or at least one or some of them) will typically be executed for whole data set/layer to find all suitable candidates rather than only a single instance.

Alternatively, one or more of the above mentioned simplifying or optimising functions/methods (or a part or parts thereof) may be implemented to process data in the graph data instead of the first data representation. The above description is still applicable changing end point to node and line segment to edge. It is however, more computationally efficient - at least for some applications - to process the data in the first data representation.

At step 803, data representing a (or at least one) geometric entity as disclosed herein is obtained or provided from map data according to a first data representation being technical drawing data, such as CAD data (see e.g. 101 in Figure 5). The data typically includes values for relevant parameters (e.g. coordinates in an overall/reference coordinate system), the type of the geometric entity, and e.g. additional data/meta-data.

At step 804, the type of the obtained geometric entity is determined among a number of possible types. The type is typically one of predetermined basic or fundamental types according to or as supported by the technical drawings/CAD data, e.g. one of a number of predetermined basic or fundamental types such as "point", "polyline", "polygon", "circle", "arc", "spline", "ellipse", "annotation", "multi-patch", etc.

At step 805, respective end points of each line segment of the geometric entity is determined. The way to determine respective end points typically depend on the type of geometric entity, e.g. is it a polyline or a circle, etc. For example a point, line/polyline, polygon, and similar, only comprises none (for a point) or exclusively one or more line segments while a circle, arc, etc. does not disclose any line segments.

Step 805 may additionally comprise the functionality of converting or replacing non-line segments of the geometric entity in question to or by a suitable approximating line segment version thereof, e.g. as described in connection with Figure 5. The approximating line segment version may e.g. be connected line segments of a piece-wise linear approximating version. The piece-wise linear segments may e.g. be of the same length or the length can vary. Alternatively, this functionality is handled by another step, e.g. a separate step or as part of initialisation step 801, step 802, or step 804 where the type of a geometric entity is determined. If all non-line segments are converted to or replaced by approximating line segment versions thereof prior to step 803 (e.g. as part of step 802), step 804 may be omitted as there is no reason (at least for this purpose) to determine the type of the geometric entity since all geometric entities will only comprise line segments (and e.g. additional data/meta data).

At step 806, a node is assigned or generated in a graph data representation as disclosed herein, e.g. as in connection with Figure 5, for each end point of the line segment(s). In at least some embodiments, a shared end point (being a coinciding end point of a plurality of different line segment) only generates one node in the graph data representation. Additionally at step 806, an edge is assigned or generated in the graph data representation as disclosed herein, e.g. as in connection with Figure 5, for each line segment connecting two end points. An edge is connected to the nodes that were generated or assigned for the end points of the line segment connecting the end points.

At step 807, values for a number of features, e.g. or preferably in the form of a feature vector, is assigned or derived for each node. The number of features is typically the same for all nodes (i.e. the feature vector for such embodiments has the same length and ordering of values/parameters for all nodes). The features/the feature vector may e.g. be or preferably is as described in connection with Figure 5 and/or as otherwise disclosed herein and the respective values will typically be numeric and at least some of them may e.g. be normalised.

These features are to be used for subsequent processing by a suitable and suitably trained GNN as disclosed herein, e.g. in order to identify or predict certain object of the graph and thereby of the underlying technical drawing/CAD data (comprising the geometric entities as obtained at step 803).

In some further embodiments, step 807 may also assign or associate other data or meta-data for other purposes, e.g. as disclosed herein and e.g. in connection with Figure 5. In particular and at least in some embodiments, a weight is assigned e.g. for each node where the weight is the total or a derived quantity of the respective lengths of the edges connected to a particular node (or rather of the respective lengths of the line segments of the first data representation that gave rise to the edges).

It is noted, that the functionality of step 807 could be executed as part of step 806 or in another suitable manner.

At step 808, it is tested whether additional geometric entities should be processed by method 800 (i.e. should generate additional node(s) and edge(s) in the graph data representation). In case of no, the method proceeds to terminating this execution of method 800 at step 809. This may e.g. be the case if all (relevant) geometric entities of the underlying technical drawing/CAD data has been processed. In case of yes, the method 800 loops back to step 803 repeating the relevant steps for a new/next geometric entity.

The generated graph data representation may be referred to as a main/geometrical graph data representation.

It is noted, that the resulting graph data representation typically or at least can comprise sub-graphs without connections/edges between them, e.g. two non-connected buildings in the map data according to the first data representation will result in a separate sub-graph representation for each building without connection, two separate objects (e.g. two tables) inside a room will result in one sub-graph representation for each object without connection between them, etc.

Figure 8 schematically illustrates a conversion of an exemplary geometric entity as disclosed herein. Illustrated at the top of the figure is a rendered example of a very simple CAD drawing data 101 of a door and doorway as defined by appropriate data of geometric entities (here comprising a number of line segments 110 and a quarter or semi-circle 111 and a number of end points 112). Illustrated at the bottom of the figure is a result of converting the CAD data of the door and doorway 101 to a graph data representation 120 as disclosed herein where the graph comprises a number of nodes 121 and edges 122 (each end point 112 is converted to a node 121 and each line segment 110 is converted to an edge 122). Please note only some of the items are designated with a reference number for simplicity. Please also note, that the quarter/semi-circle 111 of the first data representation has been replaced by a piece-wise linear approximation as disclosed herein before, during, or after the conversion.

Figure 9 schematically illustrates an exemplary optimisation according to an embodiment of a computer-implemented method of converting map data as disclosed herein.

According to the illustrated simplifying or optimising function/method (also described in connection with Figure 7), if a particular end point 112/node 121 of a (first) line segment 110/edge 122 is at or within a predetermined distance 'T' of another (second) line segment 110'/edge 122', the particular end point 112/node 121 is 'snapped' to be at the other line segment 110'/edge 122' (e.g. at a location whether the two line segments intersect or would intersect if extended) separating the other line segment 110'/edge 122' into two line segments 110"/edges 122".

Please note, for simplicity/clarity only some end points/nodes are labelled with a reference number.

Figure 10 schematically illustrates an exemplary optimisation according to an embodiment of a computer-implemented method of converting map data as disclosed herein.

According to the illustrated simplifying or optimising function/method (also described in connection with Figure 7), it is determined whether a plurality of end points/nodes 112/121 are at or within a predetermined distance of each other or whether at least one other end point/node 112/121 is within a predetermined distance (as indicated by the dashed circle 250) from a single (then central) end point/node 112/121, and then replacing those by a single end point/node 112/121 retaining or being assigned with the line segments/edges 110/122 of the determined end points/nodes 112/121. Instead of replacing all determined end points/nodes 112/121, one can be retained (then obtaining the line segments/edges 110/122 of the other(s) being removed).

Please note, for simplicity/clarity only some end points/nodes and some line segments/edges are labelled with a reference number.

Figure 11 schematically illustrates another exemplary optimisation according to an embodiment of a computer-implemented method of converting map data as disclosed herein.

According to the illustrated simplifying or optimising function/method (also described in connection with Figure 7), an intersection 255 (the coordinates thereof) between two line segments/edges 110/122 is determined (it is noted that this intersection is not a connection between the line segments/edges) and then it is checked whether any end points/nodes 112'''/121''' are at or within a predetermined distance (as indicated by the dashed circle 250') of the intersection 255, and if so the two intersecting line segments/edges 110/122 are each replaced by two line segments/edges 110''''/122'''' (then totalling four line segments/edges instead of two) and that all are connected to the end point/node 112'''/121''' determined to be at or within the predetermined distance of the intersection 255. In a sense, the end point/node 112"'/121'" at or within the predetermined distance of the intersection 255 'becomes' (an approximation to) the intersection and the two intersecting line segments/edges 110/122 are respectively connected via this end point/node 112"'/121''' This function/method is typically most efficiently carried out for data according to the first data representation.

For simplicity/clarity only some end points/nodes and some line segments/edges are labelled with a reference number.

Figure 12 schematically illustrates yet another exemplary optimisation according to an embodiment of a computer-implemented method of converting map data as disclosed herein.

According to the illustrated simplifying or optimising function/method (also described in connection with Figure 7), it is determined whether an (first) end point/node 112""/121"", that is connected only with a single other neighbouring end point/node 112/121 (i.e. is directly connected to it by a single line segment/edge 110/122), is at or within a predetermined distance 'Y' of a further other/second end point/edge 112"'"/121""" (i.e. the further other/second end point/edge 112""'/121""' is not connected to the first/determined end point 112""/121"" or its neighbour), and if so connecting, by a new line segment/edge 110'/122' (as illustrated by the dash-dotted line), the (first) end point/node 112""/121"" with the further other/second end point/edge 112""'/121""". The length of the new line segment/edge 110'/122' may be set in different ways, e.g. as explained in connection with Figure 7 (i.e. the third predetermined vicinity or length).

For simplicity/clarity only some end points/nodes and some line segments/edges are labelled with a reference number.

Figures 13A and 13B schematically illustrate another exemplary optimisation according to an embodiment of a computer-implemented method of converting map data as disclosed herein.

According to the illustrated simplifying or optimising function/method (also described in connection with Figure 7), two parallel or substantially parallel line segments/edges 110"/122" are determined where the two at least substantially parallel line segments/edges 110"/122" at least partly overlaps in their length direction and furthermore are distanced apart (in a direction substantially perpendicular to the length direction) only by less than a predetermined distance 'X'. Figure 13A illustrates the situation where the two at least substantially parallel line segments/edges 110"/122" fully overlaps and Figure 13B illustrates the situation where they only partly overlaps. Such determined two at least substantially parallel line segments/edges 110"/122" fulfilling these criteria are replaced by a single line segment/edge 110"'/122'" comprising the combined end points/nodes 112/121 of the replaced line segments/edges 110"/122". Accordingly, two parallel or substantially parallel at least partly overlapping line segments/edges within a certain (typically relatively small) distance of each other will be merged as one while retaining all end points/nodes of the relevant line segments/edges.

For simplicity/clarity only some end points/nodes and some line segments/edges are labelled with a reference number.

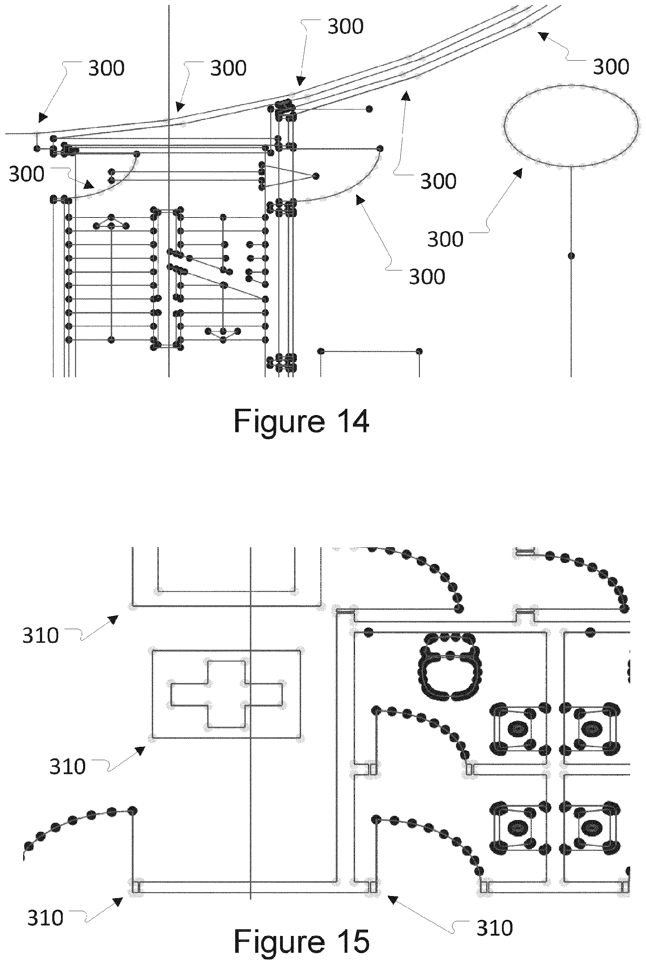

Figures 14, 15, and 16 schematically visualise exemplary nodes having different values of various features of an exemplary graph data representation. Figure 14 schematically illustrate a visualisation of nodes of a graph data representation where some nodes 300 (indicated with a brighter colour) have been determined to belong to the angle group "angle group 180" (or "angle group 170" if sampling circular structures as disclosed herein with a sampling/step angle of 10°), i.e. the nodes 300 are respective nodes each having at least two (connected) neighbour nodes (e.g. with additional neighbours with other angles) with about 170° or about 180° between the edges connecting a respective node 300 to these two neighbour nodes. As can be appreciated, such nodes 300 are good candidates for nodes being part of a circle- or part-circle structure.

Figure 15 schematically illustrate a visualisation of nodes of a graph data representation where some nodes 310 (indicated with a brighter colour) have been determined to belong to the angle group "angle group 90" (as a note, these nodes 310 does typically not arise from sampling non-linear structures), i.e. the nodes 310 are respective nodes each having at least two (connected) neighbour nodes (e.g. with additional neighbours with other angles) with 90° or about 90° between the edges connecting a respective node 310 to these two neighbour nodes. As can be appreciated, such nodes 310 are good candidates for nodes being part of a corner or corner-like structure.

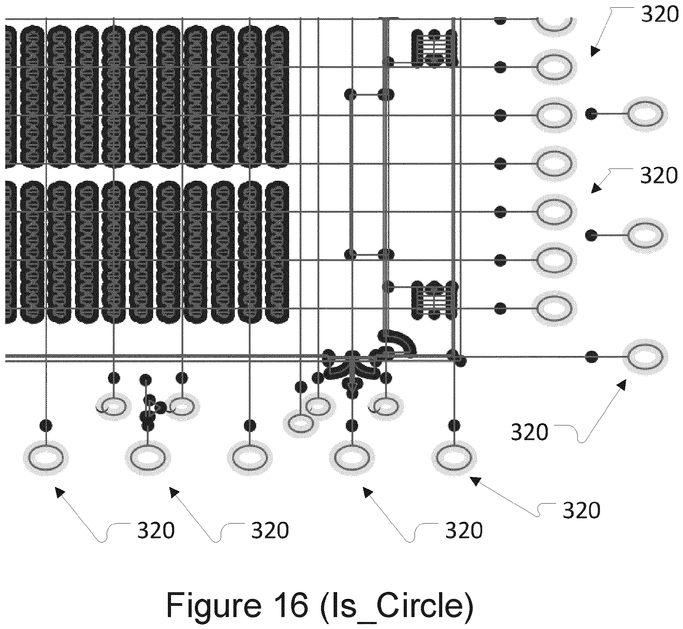

Figure 16 schematically illustrate a visualisation of nodes of a graph data representation where some nodes 320 (indicated with a brighter colour) have been determined to belong to a circle structure. In at least some embodiments, such nodes 320 may e.g. efficiently be determined by checking for nodes having two and only two neighbours that all belong to "angle group 180" (or a group as appropriate according to a used sampling/step angle) where those nodes furthermore forms (via the respective connections) a closed structure. Such nodes 320 would, at least in some embodiments, each have a value of "1" (signifying true) for the feature (e.g. of a feature vector) "Is circle" or similar.

Figure 17 schematically illustrates a functional block diagram of embodiments of an electronic data processing device or system configured to implement various embodiments of the method(s) as disclosed herein.

Shown is an electronic data processing apparatus 500 comprising one or more processing units 502 connected via one or more communications and/or data buses 501 to an electronic memory and/or electronic storage 503, and optionally one or more signal transmitter and receiver communications elements 504 (e.g. one or more of cellular, Bluetooth, WiFi, etc.) for communicating via a computer network, the Internet, and/or the like. In at least some embodiments, the electronic data processing apparatus 500 is configured to communicate with a cloud computing system 509 that may (or may not) be a distributed system. The one or more processing units 502 may e.g. include one or more CPUs, TPUs (tensor processing units), FPUs (floating point units), GPUs (graphics processing units), and/or the like.

The electronic data processing apparatus 500 may also comprise an optional display 508 and/or one or more optional (graphical and/or physical) user interface or user experience (UX) elements 507.

The electronic data processing apparatus 500 can e.g. be one or more programmed computational devices, e.g. like a PC, laptop, computer, client, server, smart-phone, tablet, etc. and is specially programmed to carry out or execute one or more of the computer-implemented methods and embodiments thereof as described throughout the specification and variations thereof.

The electronic data processing apparatus 500 (or a corresponding apparatus) may also be used to train one or more artificial intelligence, machine learning, or similar methods or components to be trained as disclosed herein, and in particular to suitably train a GNN as disclosed herein.

Some preferred embodiments have been shown in the foregoing, but it should be stressed that the invention is not limited to these but may be embodied in other ways within the subject matter defined in the following claims.

It should be emphasized that the term "comprises/comprising" when used in this specification is taken to specify the presence of stated features, elements, steps or components but does not preclude the presence or addition of one or more other features, elements, steps, components or groups thereof.

In the claims enumerating several features, some or all of these features may be embodied by one and the same element, component or item. The mere fact that certain measures are recited in mutually different dependent claims or described in different embodiments does not indicate that a combination of these measures cannot be used to advantage.

In the claims, any reference signs placed between parentheses shall not be constructed as limiting the claim. The word "comprising" does not exclude the presence of elements or steps other than those listed in a claim. The word "a" or "an" preceding an element does not exclude the presence of a plurality of such elements.

The mere fact that certain measures are recited in mutually different dependent claims does not indicate that a combination of these measures cannot be used to an advantage.

It will be apparent to a person skilled in the art that the various embodiments of the invention as disclosed and/or elements thereof can be combined without departing from the scope of the invention as defined in the claims.

## Claims

1. A computer-implemented method (800) of converting map data, the method (800) comprising:
- obtaining (801) map data according to a first data representation (101), the map data (101) representing or comprising a number of geometric entities, and
- converting (804, 805, 807) the map data according to the first data representation (101) to map data according to a second data representation (120), where the second data representation is a graph data representation (120).

2. The computer-implemented method (800) according to claim 1, wherein converting (804, 805, 807) the map data according to the first data representation (101) comprises:
- for a geometric entity of the number of geometric entities, the geometric entity comprising a number of line segments (110), each line segment (110) comprising two opposite end points (112), where an end point (112) of a line segment (110) may be shared or may be non-shared, respectively, with an end point (112) of another line segment (110),
∘ generating one node (121) in the graph data representation (120) for each non-shared end point (112),
∘ generating one node (121) in the graph data representation (120) for each shared end point (112),
∘ generating one edge (122) in the graph data representation (120) for each line segment (110) so that a generated edge (122) is connecting two generated nodes (121) in the graph data representation (120) that are generated for respective end points (112) of a line segment (110) that the edge (122) is generated for.

3. The computer-implemented method (800) according to claim 1 or 2, wherein the computer-implemented method (800) further comprises
- for geometric entities of the number of geometric entities that comprises at least a circular segment (111) and/or one or more other non-line segments, converting or replacing such geometric entities to or by an approximating line segment version before or when converting such geometric entities to the graph data representation (120).

4. The computer-implemented method (800) according to any one of claims 1 - 3, wherein the computer-implemented method (800) further comprises
- assigning a weight for at least one edge (110), the weight for an edge (122) corresponding to a length of a line segment (110) that the edge (122) is or was generated for.

5. The computer-implemented method (800) according to any one of claims 1 - 4, wherein the computer-implemented method (800) further comprises
- determining a plurality of end points (112) of line segments (110) of the first data representation (101) that are within a first predetermined vicinity or length (250) of each other or of a single one of the plurality of end points (112), and
- replacing the determined plurality of end points (112) within the first predetermined vicinity or length (250) of each other or of a single one of the plurality of end points (112) by a single end point (112) retaining or having the line segments (110) of the determined plurality of nodes (112),
and/or
- determining an end point (112') of the first data representation (101), among end points of two line segments (110, 110'), that is located within a second predetermined vicinity or length (260) of at least one of the two line segments (110, 110'), and
- replacing the determined end point (112') by a new single end point (112") on one or both of the line segments (110, 110') at the location where the two line segments (110, 110') intersect or, if not intersecting, would intersect if at least one of the two line segments (110, 110') is extended until the two line segments intersect,
and/or
- determining an end point (112"") of the first data representation (101), connected with only a single other end point (112) and being located within a third predetermined vicinity or length (270) of a further other end point (112"'"), and
- connecting the determined end point (112"") with the further other end point (112""') by a new line segment (110'),
and/or
- determining two at least substantially parallel line segments (110") of the first data representation (101) that at least partly overlaps in their length direction and are distanced apart by less than a fourth predetermined vicinity or length (280) in a direction substantially perpendicular to the length direction of the at least two substantially parallel line segments (110"), and
- replacing the two at least substantially parallel line segments (110") with a single line segment (110"') comprising the combined end points (112) of the replaced two at least substantially parallel line segments (110").

6. The computer-implemented method (800) according to any one of claims 1 - 5, wherein the computer-implemented method (800) further comprises
- determining a position or set of coordinates (255) of where two line segments (110) of the number of geometric entities of the first data representation (101) intersect, and
- determining whether an end point (112"') is located within a fifth predetermined vicinity or length (250') of the determined position or set of coordinates, and if so then replacing the line segment (110) for each of the two intersecting line segments (110) with two line segments (110"") and connecting respective line segments (110"") to the end point (112"') determined to be within the fifth predetermined vicinity or length (250') of the determined position or set of coordinates (255).

7. The computer-implemented method (800) according to any one of claims 1 - 6, wherein the computer-implemented method (800) further comprises
- assigning a value for each of a number of predetermined features for each node of the graph data representation, wherein each of the predetermined features characterises an aspect of the node in question and its context.

8. The computer-implemented method (800) according to claim 7, wherein the values of the predetermined features are provided to an input part or input layer of a graph neural network, e.g. a graph convolutional neural network, for subsequent data processing.

9. The computer-implemented method (800) according to claim 7 or 8, wherein the predetermined features for a particular node (121) comprises one or more selected from the group of:
- a minimum length of edge(s) connected to the particular node (121),
- a maximum length of edge(s) connected to the particular node (121),
- indication of which angle group(s), if any, of a plurality of different angle groups, the particular node (121) is determined to belong to,
- for each angle group, a number of occurrences that the particular node (121) is determined to belong to a respective angle group,
- a number of one or more neighbouring nodes (121) determined to be orthogonal to each other as seen from the particular node (121),
- a circle probability representing a probability of the particular node (121) being determined to be part of a circle,
- an indication of whether the particular node (121) is determined to be part of a circle or not,
- an indication of whether the particular node (121) is determined to be part of a half circle,
- an indication of whether the particular node (121) is determined to be part of a quarter circle,
- an indication of whether the particular node (121) is determined to be part of an angle group representing a corner,
- a shortest Euclidean distance or length between the particular node (121) and a node determined to belong to an angle group representing a quarter circle,
- a shortest topological graph distance or length between the particular node (121) and a node determined to belong to the angle group representing a quarter circle,
- a shortest topological graph distance or length between the particular node (121) and a node determined to belong to an angle group representing a half-circle,
- a shortest Euclidean distance or length between the particular node (121) and a node determined to belong to the angle group representing a half-circle, and
- an identifier or indication of which type of geometric entity the particular node arises from.

10. The computer-implemented method (800) according to any one of claims 1 - 9, wherein the nodes (121) of the graph data representation (120) are non-ordered and/or the graph data representation (120) is undirected.

11. A computer-implemented method of detecting or predicting a presence of at least one object in map data according to a first data representation (101), the map data (101) representing or comprising a number of geometric entities, wherein one or more of the number of geometric entities represents or defines an object to be detected or to have its presence predicted,
- converting (804, 805, 807) the map data according to the first data representation (101) to map data according to a second data representation (120), e.g. or preferably according to the method according to any one claims of 1 - 9, where the second data representation is a graph data representation (120),
- detecting or identifying one or more objects in the map data according to the second data representation (120) in response to providing the map data according to the second data representation to a computer program or routine implementing a trained graph artificial intelligence or machine learning method or component, e.g. or preferably a trained graph neural network (GNN), to generate or output the detected or identified one or more objects.

12. An electronic data processing system (500), comprising:
- one or more processing units (502) connected to an electronic memory (503), wherein the one or more processing units (502) are programmed and configured to execute the computer-implemented method (800) according to any one of claims 1 -10 and/or to execute the computer-implemented method according to claim 11.
